# EUROPEAN PATENT APPLICATION

(11) **EP 4 825 935 A1**
(43) Date of publication of application: **21.10.2026**
(21) Application number: 24903331.7
(22) Date of filing: 18.10.2024
(51) Int. Cl.: C09J 7/35, B32B 37/12, C09J 7/28, H01L 23/36

(54) **MANUFACTURING METHOD FOR ADHESIVE SHEET EQUIPPED WITH METAL SHEET AND ADHESIVE SHEET EQUIPPED WITH METAL SHEET**

(30) Priority: 12.12.2023 JP 2023209529
(71) Applicant: Nitto Shinko Corporation, Sakai-shi, Fukui 910-0381 (JP)
(72) Inventor: NAKANO, Tatsuro, Sakai-shi, Fukui 910-0381 (JP)
(74) Representative: Stolmár & Partner Patentanwälte PartG mbB
(86) International application number: PCT/JP2024/037087
(87) International publication number: WO 2025/126668

(57) **Abstract**

A method for producing a metal sheet attached adhesive sheet according to the present invention includes cutting a laminate sheet including a metal layer made of a metal sheet and an adhesive layer made of a thermosetting adhesive sheet to form the metal sheet attached adhesive sheet including the metal layer and the adhesive layer. In the laminate sheet, the metal sheet has a first surface and a second surface that is an opposite surface to the first surface. The thermosetting adhesive sheet has a first adhesive surface and a second adhesive surface that is an opposite surface to the first adhesive surface. The first surface of the metal sheet and the second adhesive surface of the thermosetting adhesive sheet are bonded to each other. The thermosetting adhesive sheet is made of an epoxy resin composition including an epoxy resin and an inorganic filler. The metal sheet attached adhesive sheet has an inclined surface on at least a part of an end surface of the metal layer, in which an angle between the inclined surface and the second surface is obtuse.

## Description

### CROSS-REFERENCE TO RELATED APPLICATION

This application claims priority to Japanese Patent Application No. 2023-209529, the disclosure of which is incorporated herein by reference in its entirety.

### FIELD

The present invention relates to a method for producing a metal sheet attached adhesive sheet, and a metal sheet attached adhesive sheet.

### BACKGROUND

Conventionally, widely used are semiconductor modules in which semiconductor elements are molded with a molding resin. Since such semiconductor modules generate heat when energized, various heat dissipation means have been taken to suppress the junction temperature in the semiconductor modules from reaching a specific value or higher. Known as one of the heat dissipation means for a heating element requiring heat dissipation, such as the above semiconductor modules, is a method in which a metal sheet attached adhesive sheet is used. In this method, a metal sheet is bonded to the heating element as an adherend via an adhesive sheet, and heat dissipation is carried out through the metal sheet.

Known as the adhesive sheet is a thermosetting adhesive sheet including an epoxy resin, in terms of having good adhesiveness to various adherends and excellent heat resistance. Also known as the thermosetting adhesive sheet is an adhesive sheet made of an epoxy resin composition including an epoxy resin and an inorganic filler, in terms of exhibiting good thermal conductivity from the heating element to the metal sheet.

Such a metal sheet attached adhesive sheet is produced by, for example, a method in which a laminate sheet including a metal layer made of the metal sheet and an adhesive layer made of the thermosetting adhesive sheet is cut into pieces. The epoxy resin composition before being fully cured is usually in a brittle state. Therefore, the metal sheet attached adhesive sheet has a problem that the adhesive layer easily peels off from the metal sheet.

The peeling of the adhesive layer tends to occur in the case where, for example, strong bending stress is applied to the metal sheet attached adhesive sheet. Patent Literature 1 discloses that, in order to easily take out a metal sheet attached adhesive sheet one by one from a plurality of the metal sheet attached adhesive sheets stacked on each other, an outer peripheral end surface of the metal sheet partially or entirely extends outward in a direction away from the thermosetting adhesive sheet.

### CITATION LIST

### Patent Literature

Patent Literature 1: JP 6829998 B

### SUMMARY

### Technical Problem

When the outer peripheral end surface of the metal sheet is made to extend outward in the direction away from the thermosetting adhesive sheet, the metal sheet has an edge with an acute angle, which is likely to damage a material to be in contact with the edge. Therefore, for example, an operator is required to handle the metal sheet attached adhesive sheet carefully to avoid damage to his or her fingertips. It is therefore an object of the present invention to provide a metal sheet attached adhesive sheet easy to handle. It is also an object of the present invention to provide a method for producing a metal sheet attached adhesive sheet easy to handle.

### Solution to Problem

Provided in the present invention to solve the problem as above is a method for producing a metal sheet attached adhesive sheet according to the present invention, the method including: cutting a laminate sheet including a metal layer made of a metal sheet and an adhesive layer made of a thermosetting adhesive sheet to form the metal sheet attached adhesive sheet including the metal layer and the adhesive layer, in which, in the laminate sheet, the metal sheet has a first surface and a second surface that is an opposite surface to the first surface, the thermosetting adhesive sheet has a first adhesive surface and a second adhesive surface that is an opposite surface to the first adhesive surface, the first surface of the metal sheet and the second adhesive surface of the thermosetting adhesive sheet are bonded to each other, the thermosetting adhesive sheet is made of an epoxy resin composition including an epoxy resin and an inorganic filler, and the metal sheet attached adhesive sheet has an inclined surface on at least a part of an end surface of the metal layer, in which an angle between the inclined surface and the second surface is obtuse.

Provided in the present invention to solve the problem as above is a metal sheet attached adhesive sheet including: a metal layer made of a metal sheet; and an adhesive layer made of a thermosetting adhesive sheet, in which the metal sheet has a first surface and a second surface that is an opposite surface to the first surface, the thermosetting adhesive sheet has a first adhesive surface and a second adhesive surface that is an opposite surface to the first adhesive surface, the first surface of the metal sheet and the second adhesive surface of the thermosetting adhesive sheet are bonded to each other, the thermosetting adhesive sheet is made of an epoxy resin composition including an epoxy resin and an inorganic filler, and the metal sheet attached adhesive sheet has an inclined surface on at least a part of an end surface of the metal layer, in which an angle between the inclined surface and the second surface is obtuse.

### BRIEF DESCRIPTION OF DRAWINGS

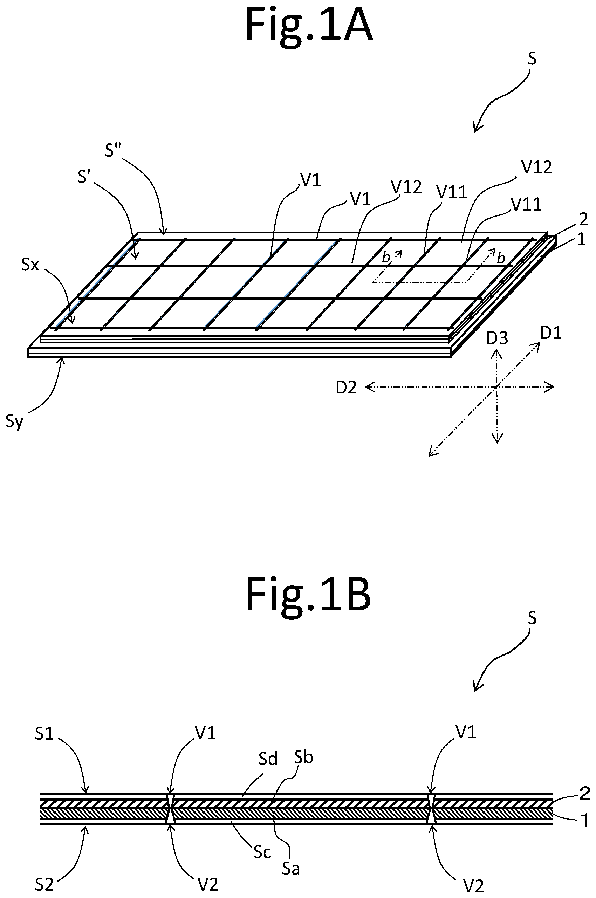

Fig. 1A is a schematic view showing a laminate sheet used as a material sheet of a metal sheet attached adhesive sheet according to one embodiment of the present invention.
Fig. 1B is a cross-sectional view showing the laminate sheet in cross section (cross-sectional view taken along arrows b-b in Fig. 1A).

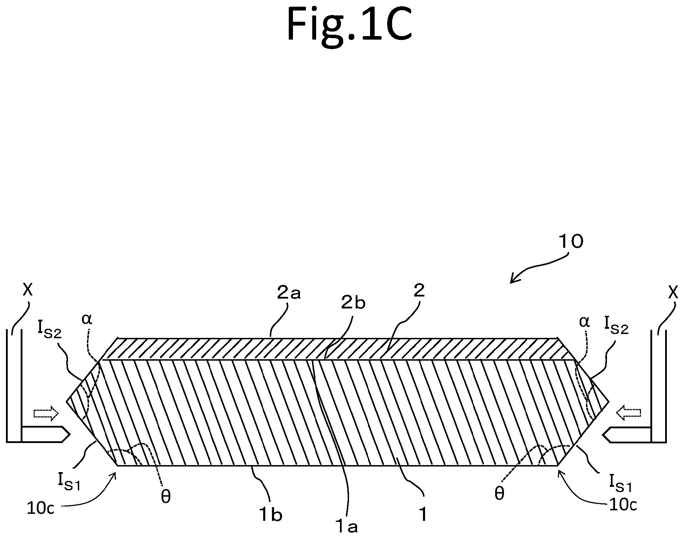

Fig. 1C is a cross-sectional view showing the metal sheet attached adhesive sheet according to one embodiment of the present invention.

### DESCRIPTION OF EMBODIMENTS

A description will be hereinafter given on one embodiment of the present invention.

### (Material sheet)

A metal sheet attached adhesive sheet according to this embodiment is obtained by being cut out from a laminate sheet including a metal layer made of a metal sheet and an adhesive layer made of a thermosetting adhesive sheet. That is, in this embodiment, the laminate sheet is used as a material sheet of the metal sheet attached adhesive sheet. Fig. 1A and Fig. 1B are respectively a schematic view and a cross-sectional view of the laminate sheet (material sheet S) immediately before being divided into pieces of the metal sheet attached adhesive sheet. Fig. 1C is a cross-sectional view showing a cross-sectional structure of a metal sheet attached adhesive sheet 10 that has been cut out from the material sheet S.

The material sheet S according to this embodiment includes a first surface Sx and a second surface Sy that is an opposite surface to the first surface Sx. The material sheet S according to this embodiment has a quadrilateral shape in plan view.
The material sheet S having a quadrilateral shape has four corners all having right angles. The material sheet S has a first direction (hereinafter referred to also as vertical direction D1) along two parallel sides out of four sides defining the material sheet S having a quadrilateral shape, and a second direction (hereinafter referred to also as horizontal direction D2) along the remaining two parallel sides. In the material sheet S according to this embodiment, the first direction and the second direction are orthogonal to each other. The material sheet S further has a third direction (hereinafter referred to also as thickness direction D3) orthogonal respectively to the first direction and the second direction.

The material sheet S according to this embodiment is the laminate sheet including a metal layer 1 made of a metal sheet Sa and an adhesive layer 2 made of a thermosetting adhesive sheet Sb. The metal sheet Sa according to this embodiment has a first surface 1a and a second surface 1b that is an opposite surface to the first surface 1a. The first surface 1a of the metal sheet Sa is located on a side of the first surface Sx of the material sheet S. The second surface 1b of the metal sheet Sa is located on a side of the second surface Sy of the material sheet S.

The thermosetting adhesive sheet Sb according to this embodiment is made of an epoxy resin composition including an epoxy resin and an inorganic filler. The thermosetting adhesive sheet Sb according to this embodiment has a first adhesive surface 2a and a second adhesive surface 2b that is an opposite surface to the first adhesive surface 2a. The first adhesive surface 2a of the thermosetting adhesive sheet Sb is located on the side of the first surface Sx of the material sheet S. The second adhesive surface 2b of the thermosetting adhesive sheet Sb is located on the side of the second surface Sy of the material sheet S.

The material sheet S (laminate sheet) according to this embodiment is made to have the first surface 1a of the metal sheet Sa and the second adhesive surface 2b of the thermosetting adhesive sheet Sb bonded to each other. The material sheet S according to this embodiment includes a protective sheet Sc removably bonded to the second surface 1b of the metal sheet Sa. In the material sheet S according to this embodiment, the first adhesive surface 2a of the thermosetting adhesive sheet Sb is an adhesive surface used for adhesion to an adherend. Thus, the material sheet S according to this embodiment further includes a separator sheet Sd bonded to the first adhesive surface 2a of the thermosetting adhesive sheet Sb to protect the first adhesive surface 2a. That is, the material sheet S according to this embodiment has a four-layer structure.

In the material sheet S according to this embodiment, the metal sheet Sa and the protective sheet Sc are laminated with their outer peripheral edges aligned, and the thermosetting adhesive sheet Sb and the separator sheet Sd are laminated with their outer peripheral edges aligned. In the material sheet S according to this embodiment, the thermosetting adhesive sheet Sb is slightly smaller than the metal sheet Sa. Thus, the material sheet S according to this embodiment has the first surface Sx slightly smaller than the second surface Sy. In the material sheet S according to this embodiment, the metal sheet Sa extends outward beyond the thermosetting adhesive sheet Sb. The material sheet S is not limited to such a configuration. The material sheet S can also be configured such that the metal sheet Sa and the thermosetting adhesive sheet Sb sharing the same size are laminated with their outer peripheral edges aligned.

The material sheet S is larger than the metal sheet attached adhesive sheet 10. The material sheet S has such a size as to be capable of cutting out a plurality of the metal sheet attached adhesive sheets 10 therefrom. In this embodiment, each of the metal sheet attached adhesive sheets 10 has a quadrilateral shape. Similar to the material sheet S, the metal sheet attached adhesive sheet 10 having a quadrilateral shape has four corners all having right angles. In this embodiment, the metal sheet attached adhesive sheet 10 having a quadrilateral shape is cut out from the material sheet S so as to have four sides parallel to the respective sides of the material sheet S.

The material sheet S has a size large enough for a plurality of metal sheet attached adhesive sheets 10 to be aligned with each other in any one of the vertical direction D1 and the horizontal direction D2. The material sheet S of this embodiment has a size large enough for a plurality of metal sheet attached adhesive sheets 10 to be aligned in each of the vertical direction and the horizontal direction. That is, the material sheet S of this embodiment is 4 times (2 × 2) as large as or larger than the metal sheet attached adhesive sheet 10.

In this embodiment, the material sheet S has a V-groove formed therein, along which the material sheet S is cut into the individual metal sheet attached adhesive sheets 10. The material sheet S has a product area S' used for the metal sheet attached adhesive sheets 10, and a non-product area S" not used for producing the metal sheet attached adhesive sheets 10. The material sheet S of this embodiment has a quadrilateral shape with the product area S' slightly smaller than the material sheet S. The material sheet S of this embodiment has a quadrilateral shape slightly smaller than the thermosetting adhesive sheet Sb. The non-product area S" of this embodiment is disposed to surround the product area S'. That is, the non-product area S" in this embodiment has a quadrilateral frame shape forming the outer peripheral portion of the material sheet S.

The material sheet S of this embodiment is used to form the metal sheet attached adhesive sheet 10 having a specific shape. The metal sheet attached adhesive sheet 10 made of the material sheet S has at least a part of an end surface of the metal layer 1 formed to have an inclined surface. An angle θ1 between the inclined surface and the second surface 1b is obtuse.

In this embodiment, the product area S' is divided by a disc cutter into a plurality of divided pieces, which are used as the metal sheet attached adhesive sheets 10. The disc cutter has a cutting edge that tapers radially outward when viewed in a direction orthogonal to an axial center of the disc cutter. That is, the disc cutter in this embodiment is configured to form a groove having a V-shape in cross section (V-groove) in a material when the cutting edge is brought into contact with the material while the disc cutter is rotating.

The material sheet S before the product area S' is cut into pieces has the V-grooves formed by the disc cutter on both the first surface Sx, which is a side on which the thermosetting adhesive sheet Sb is disposed out of the metal sheet Sa and the thermosetting adhesive sheet Sb, and the second surface Sy that is the opposite surface to the first surface.

The material sheet S has a first surface side V-groove V1 formed on the first surface side, and a second surface side V-groove V2 formed on the second surface side. The first surface side V-groove V1 includes a plurality of vertical grooves V11 formed to extend in the vertical direction D1, and a plurality of horizontal grooves V12 formed to extend in the horizontal direction D2. The same applies to the second surface side V-groove V2 in terms of having the plurality of vertical grooves and the plurality of horizontal grooves.

The plurality of vertical grooves V11 are formed parallel to each other at specific intervals in the horizontal direction D2. The plurality of horizontal grooves V12 are formed parallel to each other at specific intervals in the vertical direction D1.

The first surface side V-groove V1 and the second surface side V-groove V2 have their vertical grooves positioned to coincide with each other. The first surface side V-groove V1 and the second surface side V-groove V2 have their horizontal grooves positioned to coincide with each other.

The first surface side V-groove V1 and the second surface side V-groove V2 can be connected to each other or can be separated from each other at the deepest parts of the grooves. When the first surface side V-groove V1 and the second surface side V-groove V2 are connected to each other, the metal sheet attached adhesive sheets 10 can be readily obtained from the material sheet S. When the first surface side V-groove V1 and the second surface side V-groove V2 are separated from each other, the metal sheet attached adhesive sheets 10 adjacent to each other are connected to each other in a central portion in the thickness direction D3 of the material sheet S. This configuration allows the plurality of the metal sheet attached adhesive sheets to be handled as a single sheet. When the metal sheet attached adhesive sheets are connected to each other, the individual metal sheet attached adhesive sheets can be obtained by breaking the connecting portions.

To make the metal sheet attached adhesive sheets adjacent to each other in a connected state, the metal sheet attached adhesive sheets can be connected at the metal layer 1 or at the adhesive layer 2. Connecting at the metal layer 1 raises a problem that burrs tend to occur at the time of breaking the connecting portions. Connecting at the adhesive layer 2, however, becomes less likely to raise such a problem, thereby easily obtaining the metal sheet attached adhesive sheet 10 that hardly damages the material to be in contact with the end surface of the metal sheet attached adhesive sheet 10. Connecting at the metal layer 1, on the other hand, is unlikely to produce, e.g., dust at the time of breaking the connecting portions. Dust can be prevented from being generated by having the metal sheet attached adhesive sheets connected to each other with the adhesive layer 2, and heating the adhesive layer 2 to somewhat soften the adhesive layer 2 at the time of the breaking.

The material sheet S can be configured such that either grooves out of the vertical grooves and the horizontal grooves are formed to have the metal sheet attached adhesive sheets connected to each other while the other grooves are formed to have the metal sheet attached adhesive sheets separated. In this case, only the second surface side V-groove V2 can be formed for either V-grooves out of the vertical grooves and the horizontal grooves. That is, for either grooves out of the vertical grooves and the horizontal grooves, the configuration can be such that the second surface side V-groove V2 is formed to reach a portion of the thermosetting adhesive sheet Sb near the first adhesive surface 2a while the first surface side V-groove V1 is formed only for the other grooves out of the vertical grooves and the horizontal grooves. In the case where the material sheet S includes the separator sheet Sd, the configuration can be such that the second surface side V-groove V2 for either grooves out of the vertical grooves and the horizontal grooves is formed to reach an intermediate portion of the separator sheet Sd so as not to completely cut off the separator sheet Sd. In this case, the separator sheet Sd is connected in any of the vertical direction D1 and the horizontal direction D2, which can prevent the metal sheet attached adhesive sheets 10 from breaking up. Conversely, the configuration can be such that only the first surface side V-groove V1 is formed for either V-grooves out of the vertical grooves and the horizontal grooves. In this case, the configuration can be such that the first surface side V-groove V1 for either grooves out of the vertical grooves and the horizontal grooves is formed to reach a position of the metal sheet Sa near the second surface 1b, or is formed to reach an intermediate portion of the protective sheet Sc. This configuration can still prevent the metal sheet attached adhesive sheets 10 from breaking up.

In any of the above cases, obtained can be the metal sheet attached adhesive sheet 10 with the angle θ1 being obtuse between the second surface 1b and each of the inclined surfaces located at two opposed sides of the metal sheet attached adhesive sheet 10 having a quadrilateral shape. In this case, as shown in Fig. 1C, an inclined surface I_{S1} connected to an end edge of the second surface 1b at an angular part 10c is formed to extend outward from the second surface 1b toward the first surface 1a, and the inclined surfaces I_{S1} are formed to extend from both ends of the second surface 1b, respectively. This configuration enables the metal sheet attached adhesive sheet 10 to be easily picked up by, e.g., a pair of members X including claws that can come into contact with the inclined surfaces I_{S1} from the sides of the metal sheet attached adhesive sheet 10. Accordingly, the plurality of metal sheet attached adhesive sheets 10 stacked on each other in the thickness direction can be easily picked up one by one. In this embodiment, the configuration that the metal sheet attached adhesive sheets 10 are easily picked up one by one using the inclined surfaces I_{S1} allows interfacial delamination between the metal layer 1 and the adhesive layer 2 to hardly occur when handling the metal sheet attached adhesive sheets 10.

The metal sheet attached adhesive sheet 10 of this embodiment having the inclined surfaces I_{S1} can still be easily picked up from a work table even when the metal sheet attached adhesive sheet 10 is placed to have the second surface 1b of the metal sheet Sa in direct contact with a work surface of the work table. The metal sheet attached adhesive sheet 10 of this embodiment configured to have the central portion in the thickness direction protruding outward is easily picked up from the work table when the metal sheet attached adhesive sheet 10 is placed on the work table not only with the metal sheet Sa facing downward but also with the metal sheet Sa facing upward. As described above, the material sheet S of this embodiment can be advantageous in forming the metal sheet attached adhesive sheet 10 easy to handle.

The metal sheet Sa forming the metal layer 1 in the material sheet S can be a sheet made of, for example, a metal such as copper, aluminum, iron, nickel, tin, magnesium, gold, or silver, or made of an alloy based on the metal. The metal sheet Sa can be made of a clad material having a plurality of metal layers.

The thickness of the metal sheet Sa is not particularly limited. The thickness of the metal sheet Sa can be, for example, 0.1 mm or more. The thickness of the metal sheet Sa can be 0.2 mm or more, 0.3 mm or more, 0.4 mm or more. The thickness of the metal sheet Sa can be 0.5 mm or more, 0.8 mm or more. The thickness of the metal sheet Sa can be, for example, 10 mm or less. The thickness of the metal sheet Sa can be 8 mm or less, 6 mm or less, 4 mm or less. The thickness of the metal sheet Sa can be 3 mm or less, 2 mm or less.

The metal sheet Sa can have one or both of the first surface a1 and the second surface 1b subjected to surface treatment such as plating treatment, oxidation treatment, matting treatment, hairline treatment, rust prevention treatment (antioxidation treatment). The metal sheet Sa of this embodiment is preferably a copper plate or an aluminum plate in terms of having excellent thermal conductivity. The copper plate can be subjected to oxidation treatment such as blackening treatment, or can be subjected to matting treatment (roughening treatment) such as blasting treatment. The aluminum plate can be subjected to anodizing treatment such as phosphoric acid anodizing treatment or sulfuric acid anodizing treatment, or subjected to, for example, sealing treatment.

In this embodiment in which interfacial delamination between the metal layer 1 and the adhesive layer 2 is suppressed, the metal sheet Sa can have a surface not subjected to any particular treatment. In this embodiment, an untreated material, which is a rolled material made of, e.g., copper or aluminum (i.e., rolled copper plate, rolled aluminum plate) not subjected to surface treatment, can be used as the metal sheet Sa. The metal sheet Sa is suitable in terms of being available at low cost.

In this embodiment, the epoxy resin included in the epoxy resin composition is not particularly limited, either. As the epoxy resin included in the epoxy resin composition, used can be various known epoxy resins such as a triphenylmethane-type epoxy resin, a cresol novolac-type epoxy resin, a biphenyl-type epoxy resin, a modified bisphenol A-type epoxy resin, a bisphenol A-type epoxy resin, a bisphenol F-type epoxy resin, a modified bisphenol F-type epoxy resin, a dicyclopentadiene-type epoxy resin, a phenol novolac-type epoxy resin, and a phenoxy resin. These various epoxy resins can be individually used, or two or more of them can be used in combination. Among these, the triphenylmethane-type epoxy resin is preferable as the epoxy resin in the epoxy resin composition, and it is more preferable that the triphenylmethane-type epoxy resin account for 80 mass % or more of the epoxy resin in the thermosetting adhesive sheet.

The content of the epoxy resin based on 100 mass parts of the epoxy resin composition is preferably 5 mass parts or more and 25 mass parts or less, more preferably 10 mass parts or more and 25 mass parts or less, further preferably 15 mass parts or more and 20 mass parts or less.

The epoxy resin composition can include a curing agent. Examples of the curing agent include a phenol-based curing agent, an amine-based curing agent, and an anhydride-based curing agent. Examples of the phenol-based curing agent include a phenol novolac resin, an aralkyl-type phenolic resin, a dicyclopentadiene modified phenolic resin, a naphthalene-type phenolic resin, and a bisphenol-based phenolic resin. Examples of the amine-based curing agent include diaminodiphenylsulfone, dicyandiamide, diaminodiphenylmethane, and triethylenetetramine. Among these, preferable as the curing agent in the epoxy resin composition is the phenol-based curing agent, among which the aralkyl-type phenolic resin is more preferable. Examples of the aralkyl-type phenolic resin include xylylene novolac phenol, and bisphenol novolac phenol.

The content of the curing agent based on 100 mass parts of the epoxy resin composition is preferably 4 mass parts or more and 25 mass parts or less, more preferably 7 mass parts or more and 20 mass parts or less, further preferably 10 mass parts or more and 15 mass parts or less.

The epoxy resin composition can include a curing accelerator. As the curing accelerator, it is preferable to use an imidazole-based curing accelerator, an amine-based curing accelerator, or the like in consideration of shelf life. Examples of the amine-based curing accelerator include triphenylphospate (TPP) and boron trifluoride monoethylamine.

The content of the curing accelerator based on 100 mass parts of the epoxy resin composition is preferably 0.10 mass part or more and 0.40 mass part or less, more preferably 0.15 mass part or more and 0.35 mass part or less, further preferably 0.20 mass part or more and 0.30 mass part or less.

Examples of the inorganic filler in the epoxy resin composition include an inorganic nitride filler, an inorganic oxide filler, diamond, talc, clay, and calcium carbonate. Examples of the inorganic nitride filler include boron nitride, aluminum nitride, and silicon nitride. Examples of the inorganic oxide filler include silicon oxide (silica), aluminum oxide (alumina), titanium oxide (titania), and zirconium oxide (zirconia). Among these, preferable as the inorganic filler in the epoxy resin composition is at least one selected from the group consisting of boron nitride, aluminum oxide, and silicon oxide. Further, it is more preferable that the epoxy resin composition include, as the inorganic filler, a mixture including boron nitride and aluminum oxide, or a mixture including boron nitride and silicon oxide. In the mixture, the content of the boron nitride is preferably 50 mass % or more and 95 mass % or less.

In allowing the metal sheet attached adhesive sheet 10 to exhibit excellent thermal conductivity, it is more advantageous to highly load the thermosetting adhesive sheet Sb with the inorganic filler, since the inorganic filler has a higher thermal conductivity than the epoxy resin. When the thermosetting adhesive sheet Sb includes boron nitride as the inorganic filler, the content of the boron nitride in the thermosetting adhesive sheet is preferably 30 volume % or more, more preferably 40 volume % or more, further preferably 50 volume % or more. The configuration that the content of the boron nitride in the thermosetting adhesive sheet is 30 volume % or more allows the thermosetting adhesive sheet Sb to have excellent thermal conductivity. On the other hand, the content of the boron nitride in the thermosetting adhesive sheet is preferably 65 volume % or less in terms of allowing the thermosetting adhesive sheet Sb to exhibit excellent adhesiveness, mechanical strength, and electrical insulation. The content of the boron nitride in the thermosetting adhesive sheet Sb represents a value at 20 °C.

The thermosetting adhesive sheet has a thermal conductivity of preferably 5 W/m·K or more, more preferably 7 W/m·K or more, further preferably 10 W/m·K or more. In terms of allowing the thermosetting adhesive sheet to exhibit excellent adhesiveness and mechanical strength, the content of the inorganic filler in the thermosetting adhesive sheet is limited. Thus, the thermal conductivity of the thermosetting adhesive sheet is usually 20 W/m·K or less.

The thermosetting adhesive sheet has a volume resistivity of preferably 1 × 10¹² Ω · cm or more. It is preferable that the thermosetting adhesive sheet having a volume resistivity of 1 × 10¹³ Ω · cm or more exhibit more sufficient electrical insulation. It is difficult to expect the thermosetting adhesive sheet to exhibit too much electrical insulation since the thermosetting adhesive sheet is highly loaded with the inorganic filler. Thus, the volume resistivity of the thermosetting adhesive sheet is usually 1 × 10¹⁸ Ω · cm or less.

The epoxy resin composition can include various additives. Examples of the additives include a product generally used as a plastic compounding chemical such as a dispersant, a tackifier, an anti-aging agent, an antioxidant, a stabilizer, a defoamer, a fire retardant, a thickener, or a pigment.

In the material sheet S of this embodiment, the thickness of the adhesive layer 2 made of the thermosetting adhesive sheet Sb is not particularly limited, either. The thickness of the adhesive layer 2 can be, for example, 100 µm or more. The thickness of the adhesive layer 2 can be 150 µm or more, 200 µm or more, 250 µm or more. The thickness of the adhesive layer 2 can be, for example, 1000 µm or less. The thickness of the adhesive layer 2 can be 750 µm or less, 600 µm or less, 450 µm or less.

For the protective sheet Sc, an adhesive sheet with a polyvinyl chloride resin film, a polyethylene resin film, a polyethylene terephthalate resin film, or the like as a backing material can be used. That is, the protective sheet Sc can be an adhesive sheet including a backing material layer and the adhesive layer. It is preferable that the protective sheet Sc have flexibility to exhibit excellent followability to the second surface 1b of the metal sheet Sa. The protective sheet Sc can be left bonded to the metal sheet Sa without being removed therefrom when the V-groove is formed in the metal sheet Sa. In such a case, it is desirable that the protective sheet Sc have moderate stiffness in exhibiting good grindability. In this regard, the protective sheet Sc is preferably the adhesive sheet with the polyethylene rein film as the backing material.

The thickness of the polyethylene resin film is not particularly limited. The thickness of the polyethylene resin film can be, for example, 10 µm or more. The thickness of the polyethylene resin film can be 20 µm or more, can be 30 µm or more. The thickness of the polyethylene resin film can be, for example, 200 µm or less. The thickness of the polyethylene resin film can be 150 µm or less, can be 100 µm or less.

The separator sheet Sd can be an adhesive sheet with the adhesive layer, similar to the protective sheet Sc. It is preferable that the separator sheet Sd be a simple resin sheet with no adhesive layer, for the purpose of suppressing the likelihood of excessive adhesion between the separator sheet Sd and the adhesive layer 2. The separator sheet Sd can be, for example, a polyvinyl chloride resin film, a polyethylene resin film, or a polyethylene terephthalate resin film. The separator sheet Sd can be, for example, craft paper subjected to release treatment.

The separator sheet Sd is preferably a polyethylene terephthalate resin film of which a surface in contact with the adhesive layer 2 is subjected to matting treatment in exhibiting moderate adhesiveness and good peelability between the separator sheet Sd and the adhesive layer 2.

The thickness of the polyethylene terephthalate resin film is not particularly limited. The thickness of the polyethylene terephthalate resin film can be, for example, 25 µm or more. The thickness of the polyethylene terephthalate resin film can be 50 µm or more, can be 75 µm or more. The thickness of the polyethylene terephthalate resin film can be, for example, 500 µm or less. The thickness of the polyethylene terephthalate resin film can be 250 µm or less, can be 200 µm or less.

The thickness of each of the metal sheet Sa forming the metal layer 1, the thermosetting adhesive sheet Sb forming the adhesive layer 2, the backing material of the protective sheet Sc, and the separator sheet Sd can be measured by, e.g., a micrometer, and can be obtained as an arithmetic average value of the measured thicknesses of 10 randomly selected locations.

The material sheet S can have a two-layer structure of the metal sheet Sa and the thermosetting adhesive sheet Sb. The material sheet S can have a three-layer structure or a four-layer structure. That is, the material sheet S can further include at least one of the protective sheet Sc and the separator sheet Sd in addition to the two-layer structure of the metal sheet Sa and the thermosetting adhesive sheet Sb.

### (Metal sheet attached adhesive sheet)

The metal sheet attached adhesive sheet 10 according to this embodiment has the configuration and the thicknesses at different locations which are the same as those of the material sheet S, and thus no detailed description thereon will be repeatedly given here.

In the metal sheet attached adhesive sheet 10 according to this embodiment, the end surface defining the outer peripheral portion of the metal layer 1 is partially or entirely a first inclined surface I_{S1} extending outward from the second surface 1b toward the first surface 1a. In the metal sheet attached adhesive sheet 10 according to this embodiment, a portion of the end surface close to the second surface 1b is the first inclined surface I_{S1}.

The metal sheet attached adhesive sheet 10 according to this embodiment further includes a second inclined surface I_{S2} extending outward from the first surface 1a toward the second surface 1b and intersecting the first inclined surface I_{S1}. In the metal sheet attached adhesive sheet 10 according to this embodiment, a portion of the end surface close to the first surface 1a is the second inclined surface I_{S2}.

In the metal sheet attached adhesive sheet 10 according to this embodiment, the angle θ1 between the second surface 1b and the first inclined surface I_{S1} is obtuse. It is preferable that the first inclined surface I_{S1} be formed on all four sides, or at least two opposed sides, of the metal sheet attached adhesive sheet 10. When the first inclined surface I_{S1} is formed on a plurality of sides, angles between the second surface 1b and the respective first inclined surfaces I_{S1} can all be the same, or can be different from each other. The angle θ1 can be, for example, 95 degrees or more. The angle θ1 can be 100 degrees or more, can be 105 degrees or more. The angle θ1 can be 150 degrees or less. The angle θ1 can be 140 degrees or less, can be 135 degrees or less.

In the metal sheet attached adhesive sheet 10 according to this embodiment, an angle θ2 between the first surface 1a and the second inclined surface I_{S2} is obtuse. It is preferable that the second inclined surface I_{S2} be formed on all four sides, or at least two opposed sides, of the metal sheet attached adhesive sheet 10. When the second inclined surface I_{S2} is formed on a plurality of sides, angles between the first surface 1a and the respective second inclined surfaces I_{S2} can all be the same, or can be different from each other. The angle θ2 can be, for example, 95 degrees or more. The angle θ2 can be 100 degrees or more, can be 105 degrees or more. The angle θ2 can be 150 degrees or less. The angle θ2 can be 140 degrees or less, can be 135 degrees or less.

The first inclined surface I_{S1} and the second inclined surface I_{S2} intersect each other in the central portion in the thickness direction of the metal sheet attached adhesive sheet 10 according to this embodiment. In this embodiment, an interior angle α of this intersection is also obtuse.

The interior angle α of the intersection is usually a sum of a supplementary angle of the angle θ1 between the second surface 1b and the first inclined surface I_{S1} (180 - θ1) and a supplementary angle of the angle θ2 between the first surface 1a and the second inclined surface I_{S2} (180 - θ2), the sum being (360 - (θ1 + θ2)). To make obtuse the interior angle α of the intersection, it is preferable to satisfy a formula (1a) below, more preferable to satisfy a formula (1b) below, further preferable to satisfy a formula (1c) below: $190 \leq \left(θ1+θ2\right) < 270$ (1a) $190 \leq \left(θ1+θ2\right) \leq 265$ (1b) $200 \leq \left(θ1+θ2\right) \leq 260$ (1c)

These angles (θ1, θ2, and α) can be measured by observing, with a microscope or the like, a cross-sectional area of the metal sheet attached adhesive sheet 10 obtained by cutting the metal sheet attached adhesive sheet 10 along a plane parallel to its thickness direction and orthogonal to a side of the metal sheet attached adhesive sheet 10 subjected to angle observation. When, in the cross-sectional area, each of the first surface 1a, the second surface 1b, the first inclined surface I_{S1}, and the second inclined surface I_{S2} is not observed as a straight line but seems somewhat undulating, an approximate straight line can be obtained by the least-squares method for finding each of these angles. Each of the angles can be obtained by arithmetically averaging the measured angles in a plurality of randomly selected cross-sectional areas (e.g., 10 areas).

### (Method for producing metal sheet attached adhesive sheet)

In the method for producing the metal sheet attached adhesive sheet according to this embodiment, the laminate sheet including the metal layer 1 made of the metal sheet Sa and the adhesive layer 2 made of the thermosetting adhesive sheet Sb is used as the material sheet S, as has been described above. The method for producing of this embodiment includes cutting the material sheet S to produce the metal sheet attached adhesive sheet 10 including the metal layer 1 and the adhesive layer 2. In this embodiment, the thermosetting adhesive sheet Sb is made of the epoxy resin composition including the epoxy resin and the inorganic filler; has the first adhesive surface 2a and the second adhesive surface 2b being the opposite surface to the first surface 1a; and has the metal sheet Sa having the first surface 1a and the second surface 1b being the opposite surface to the first surface 1a. In this embodiment, the metal sheet attached adhesive sheet 10 is produced in which the material sheet S (laminate sheet) with the first surface 1a of the metal sheet Sa and the second adhesive surface 2b of the thermosetting adhesive sheet Sb bonded to each other is used, the end surface of the metal layer 1 is at least partially formed to have the inclined surface, and the angle θ1 between the inclined surface and the second surface 1b is obtuse.

In the method for producing of this embodiment, the disc cutter is used for cutting the material sheet S, as has been described above. The disc cutter usually has a disc shape, with a cutting edge located along its outer peripheral part. The disc cutter has an axial center extending in a direction orthogonal to a plate surface and passing through the center of the disc cutter. The disc cutter is configured to cut a material by bringing the outer peripheral edge of the disc cutter rotating about an axial center into contact with the material.

The device for cutting the material sheet S in this embodiment is not limited to the disc cutter. A band saw or a laser cutter can also be used for cutting the material sheet S. A shearing cutter, for example, can also be used for cutting the material sheet S as appropriate. In this embodiment, the configuration can be such that the material sheet S is cut with, e.g., a shearing cutter to first produce the metal sheet attached adhesive sheet with its end surface extending perpendicular to the second surface 1b, followed by grinding the end surface into an inclined surface to form the inclined surface.

The disc cutter has a cutting edge that tapers radially outward when viewed in a direction orthogonal to the axial center. In the V-groove formed in the material sheet S using the disc cutter configured as above, one inner wall surface and the other inner wall surface extending upward from the deepest part of the groove can each be an inclined surface. That is, while use of e.g., the shearing cutter requires two separate steps, i.e., cutting the sheet and forming the inclined surface, use of the disc cutter requires only one step to form the inclined surface. It can be an efficient method to form the first inclined surface I_{S1} by cutting the material sheet S from the side of the metal layer 1 using the disc cutter to form the V-groove in the material sheet S.

In terms of producing the metal sheet attached adhesive sheet 10b easy to handle, the configuration can also be such that the metal sheet attached adhesive sheet 10 to be produced has a quadrilateral shape, the inclined surfaces are formed on at least two out of four sides of the metal sheet attached adhesive sheet 10 having a quadrilateral shape, and the inclined surfaces are formed on two opposed sides of the quadrilateral-shaped metal sheet attached adhesive sheet 10.

In the method for producing of this embodiment, the V-grooves are formed on both the first surface Sx of the material sheet S and the second surface Sy being the opposite surface to the first surface Sx, using the disc cutter. That is, in the method for producing of this embodiment, produced can be the metal sheet attached adhesive sheet 10 configured such that the first surface side V-groove V1 on the side of the first surface Sx and the second surface side V-groove V2 on the side of the second surface Sy are formed to be along line segments that define at least a part of the outer periphery of the metal sheet attached adhesive sheet 10; the second surface side V-groove V2 forms the first inclined surface I_{S1} and the first surface side V-groove V1 forms the second inclined surface I_{S2} inclined reversely to the first inclined surface I_{S1} on the side of the first surface Sx of the material sheet S; and the central part in the thickness direction of the metal sheet attached adhesive sheet 10 protrudes outward at the positions corresponding to the line segments. This can efficiently produce the metal sheet attached adhesive sheet 10 easy to handle.

In forming the V-grooves along the line segments, the first surface side V-groove V1 can be formed after the second surface side V-groove V2 is formed. Forming the V-groove from the side of the metal layer may cause the adhesive layer 2 to be peeled near the V-groove, but forming the first surface side V-groove V1 from the side of the adhesive layer afterwards allows the peeled portion to be easily removed. When the adhesive layer is peeled in forming the second surface side V-groove V2, such peeling mainly occurs near the deepest part of the second surface side V-groove V2.

The part of the first adhesive surface 2a at which the peeling has occurred looks whiter in appearance than the surrounding area thereof. Thus, the peeling of the adhesive layer 2 if occurring near the deepest part of the second surface side V-groove V2 appears as a white line on the first adhesive surface 2a, and the degree of peeling can be understood by the width of the white line. When, for example, the peeling is hardly observed, the material sheet S can be cut by plunging the disc cutter to such a depth as to reach the deepest part of the second surface side V-groove V2 at the time of forming the first surface side V-groove V1. In the case where a certain degree of peeling occurred at the time of forming the second surface side V-groove V2, the disc cutter at the time of forming the first surface side V-groove V1 can be plunged to a depth beyond the deepest part of the second surface side V-groove V2 to a certain degree, so that the portion at which the peeling has occurred can be selectively removed.

The second surface side V-groove V2 can be formed to have its deepest part located in the metal layer 1 or located in the adhesive layer 2. The second surface side V-groove V2 can be formed to have its deepest part located to reach the separator sheet Sd through the adhesive layer 2. Forming the first surface side V-groove V1 later is effective also in removing burrs that may be generated at end edges of the first surface 1a of the metal layer 1.

The V-groove formed in the material sheet S using the disc cutter has a width orthogonal to the direction in which the V-groove extends, the width being usually smaller as it advances from the surface side of the material sheet S toward the deepest part of the V-groove. How the groove width is made smaller as it advances toward the deepest part usually is determined depending on the shape of the cutting edge of the disc cutter. In this embodiment, therefore, a plurality of the disc cutters having the cutting edges formed to have different angles can be used to form V-grooves with various different shapes in cross-section.

The disc cutter in this embodiment can be like a chip saw or a disc grinder. In this embodiment, a plurality of the disc cutters including one or more chip saws and one or more disc grinders can be used to cut the material sheet S. When the plurality of V-grooves parallel to each other are formed in the material sheet S, the V-grooves can be formed one by one using a single disc cutter, or can be collectively formed using a plurality of disc cutters.

The metal sheet attached adhesive sheet 10, which is obtained as an individual piece by forming the V-grooves in the material sheet S from the both surfaces, is subjected to removal of foreign matters adhering to the end surfaces. Thereafter, the protective sheet Sc and the separator sheet Sd are removed, the first adhesive surface 2a is exposed, and the first adhesive surface 2a is bonded to an adherend. Thereby, the metal sheet attached adhesive sheet 10 can be used for heat dissipation from the adherend. The attaching to the adherend can be carried out by heating the adhesive layer to a temperature equal to or higher than the curing temperature of the epoxy resin, and pressing the first adhesive surface 2a against the adherend.

The method for producing the metal sheet attached adhesive sheet, and the metal sheet attached adhesive sheet according to the present invention are not limited to the aforementioned embodiments. The method for producing the metal sheet attached adhesive sheet, and the metal sheet attached adhesive sheet according to the present invention are not limited by the aforementioned operational effects, either. Various modifications can be made to the method for producing the metal sheet attached adhesive sheet, and the metal sheet attached adhesive sheet according to the present invention without departing from the gist of the present invention.

The aforementioned embodiments include the following disclosures:
[1] A method for producing a metal sheet attached adhesive sheet, the method including: cutting a laminate sheet including a metal layer made of a metal sheet and an adhesive layer made of a thermosetting adhesive sheet to form the metal sheet attached adhesive sheet including the metal layer and the adhesive layer, in which, in the laminate sheet, the metal sheet has a first surface and a second surface that is an opposite surface to the first surface, the thermosetting adhesive sheet has a first adhesive surface and a second adhesive surface that is an opposite surface to the first adhesive surface, the first surface of the metal sheet and the second adhesive surface of the thermosetting adhesive sheet are bonded to each other, the thermosetting adhesive sheet is made of an epoxy resin composition including an epoxy resin and an inorganic filler, and the metal sheet attached adhesive sheet has an inclined surface on at least a part of an end surface of the metal layer, in which an angle between the inclined surface and the second surface is obtuse.
   Such a configuration that at least a part of the end surface of the metal layer has the inclined surface and the angle between the inclined surface and the second surface is obtuse hardly damage a member in contact with the metal layer. Thus, the method for producing the metal sheet attached adhesive sheet easy to handle can be provided.
[2] The method for producing the metal sheet attached adhesive sheet according to [1], in which the metal sheet attached adhesive sheet has a quadrilateral shape, the method further including: forming the inclined surface on each of two opposed sides of the metal sheet attached adhesive sheet having a quadrilateral shape.
[3] The method for producing the metal sheet attached adhesive sheet according to [1] or [2], the method further including: forming the inclined surface by cutting the laminate sheet from a side of the metal layer using a disc cutter to form a V-groove in the laminate sheet.
[4] The method for producing the metal sheet attached adhesive sheet according to [3], the method further including: forming, using the disc cutter, the V-groove including a first surface side V-groove and a second surface side V-groove respectively in a first surface and a second surface that is an opposite surface to the first surface of the laminate sheet, so as to extend along a line segment that defines at least a part of an outer periphery of the metal sheet attached adhesive sheet, in which the inclined surface is formed by the second surface side V-groove, and another inclined surface inclined reversely to the inclined surface is formed by the first surface side V-groove on the side of the first surface of the laminate sheet, and a portion of the metal sheet attached adhesive sheet corresponding to the line segment has a center portion in its thickness direction that protrudes outward.
[5] The method for producing the metal sheet attached adhesive sheet according to [4], the method further including, in the forming of the V-groove along the line segment, forming the first surface side V-groove after forming the second surface side V-groove.
[6] A metal sheet attached adhesive sheet including: a metal layer made of a metal sheet; and an adhesive layer made of a thermosetting adhesive sheet, in which the metal sheet has a first surface and a second surface that is an opposite surface to the first surface, the thermosetting adhesive sheet has a first adhesive surface and a second adhesive surface that is an opposite surface to the first adhesive surface, the first surface of the metal sheet and the second adhesive surface of the thermosetting adhesive sheet are bonded to each other, the thermosetting adhesive sheet is made of an epoxy resin composition including an epoxy resin and an inorganic filler, and the metal sheet attached adhesive sheet has an inclined surface on at least a part of an end surface of the metal layer, in which an angle between the inclined surface and the second surface is obtuse.
   Such a configuration that at least a part of the end surface of the metal layer has the inclined surface and the angle between the inclined surface and the second surface is obtuse hardly damage a member in contact with the metal layer. Thus, the metal sheet attached adhesive sheet easy to handle can be provided.
[7] The metal sheet attached adhesive sheet according to [6], the metal sheet attached adhesive sheet having a quadrilateral shape and having the inclined surface on each of two opposed sides of the metal sheet attached adhesive sheet having the quadrilateral shape.
[8] The metal sheet attached adhesive sheet according to [6] or [7], in which a portion of the metal sheet attached adhesive sheet with the inclined surface formed thereon protrudes outward at a center portion in a thickness direction of the metal sheet attached adhesive sheet.

### REFERENCE SIGNS LIST

1: Metal layer
1a: First surface
1b: Second surface
2: Adhesive layer
2a: First adhesive surface
2b: Second adhesive surface
10: Metal sheet attached adhesive sheet
I_{S1}: First inclined surface
I_{S2}: Second inclined surface
S: Material sheet (laminate sheet)
Sa: Metal sheet
Sb: Thermosetting adhesive sheet
V1: First surface side V-groove
V2: Second surface side V-groove

## Claims

1. A method for producing a metal sheet attached adhesive sheet, the method comprising: cutting a laminate sheet comprising a metal layer made of a metal sheet and an adhesive layer made of a thermosetting adhesive sheet to form the metal sheet attached adhesive sheet comprising the metal layer and the adhesive layer, wherein
in the laminate sheet,
the metal sheet has a first surface and a second surface that is an opposite surface to the first surface,
the thermosetting adhesive sheet has a first adhesive surface and a second adhesive surface that is an opposite surface to the first adhesive surface,
the first surface of the metal sheet and the second adhesive surface of the thermosetting adhesive sheet are bonded to each other,
the thermosetting adhesive sheet is made of an epoxy resin composition comprising an epoxy resin and an inorganic filler, and
the metal sheet attached adhesive sheet has an inclined surface on at least a part of an end surface of the metal layer, wherein an angle between the inclined surface and the second surface is obtuse.

2. The method for producing the metal sheet attached adhesive sheet according to claim 1, wherein the metal sheet attached adhesive sheet has a quadrilateral shape,
the method further comprising:
forming the inclined surface on each of two opposed sides of the metal sheet attached adhesive sheet having a quadrilateral shape.

3. The method for producing the metal sheet attached adhesive sheet according to claim 1 or 2, the method further comprising:
forming the inclined surface by cutting the laminate sheet from a side of the metal layer using a disc cutter to form a V-groove in the laminate sheet.

4. The method for producing the metal sheet attached adhesive sheet according to claim 3, the method further comprising:
forming, using the disc cutter, the V-groove comprising a first surface side V-groove and a second surface side V-groove respectively in a first surface and a second surface that is an opposite surface to the first surface of the laminate sheet, so as to extend along a line segment that defines at least a part of an outer periphery of the metal sheet attached adhesive sheet, wherein
the inclined surface is formed by the second surface side V-groove, and another inclined surface inclined reversely to the inclined surface is formed by the first surface side V-groove on the side of the first surface of the laminate sheet, and
a portion of the metal sheet attached adhesive sheet corresponding to the line segment has a center portion in its thickness direction that protrudes outward.

5. The method for producing the metal sheet attached adhesive sheet according to claim 4, the method further comprising
in the forming of the V-groove along the line segment, forming the first surface side V-groove after forming the second surface side V-groove.

6. A metal sheet attached adhesive sheet comprising: a metal layer made of a metal sheet; and an adhesive layer made of a thermosetting adhesive sheet, wherein
the metal sheet has a first surface and a second surface that is an opposite surface to the first surface,
the thermosetting adhesive sheet has a first adhesive surface and a second adhesive surface that is an opposite surface to the first adhesive surface,
the first surface of the metal sheet and the second adhesive surface of the thermosetting adhesive sheet are bonded to each other,
the thermosetting adhesive sheet is made of an epoxy resin composition comprising an epoxy resin and an inorganic filler, and
the metal sheet attached adhesive sheet has an inclined surface on at least a part of an end surface of the metal layer, wherein an angle between the inclined surface and the second surface is obtuse.

7. The metal sheet attached adhesive sheet according to claim 6, the metal sheet attached adhesive sheet having a quadrilateral shape and having the inclined surface on each of two opposed sides of the metal sheet attached adhesive sheet having the quadrilateral shape.

8. The metal sheet attached adhesive sheet according to claim 6 or 7, wherein a portion of the metal sheet attached adhesive sheet with the inclined surface formed thereon protrudes outward at a center portion in a thickness direction of the metal sheet attached adhesive sheet.
